# EUROPEAN PATENT SPECIFICATION

(11) **EP 4 081 693 B1**
(45) Date of publication and mention of the grant of the patent: **17.04.2024**
(21) Application number: 20904454.4
(22) Date of filing: 22.12.2020
(51) Int. Cl.: E05B 65/48, H02B 1/38, H02B 1/40, H05K 5/02

(54) **ENCLOSURE FOR ELECTRICAL INSTALLATIONS**
GEHÄUSE FÜR ELEKTRISCHE INSTALLATIONEN
ENVELOPPE POUR INSTALLATIONS ÉLECTRIQUES

(30) Priority: 23.12.2019 FI 20196129
(43) Date of publication of application: 02.11.2022
(73) Proprietor: Fibox Oy Ab, 02150 Espoo (FI)
(72) Inventor: WEBER, Kenneth, 02150 ESPOO (FI)
(74) Representative: Kolster Oy Ab
(86) International application number: PCT/FI2020/050864
(87) International publication number: WO 2021/130414

(56) References cited:
- WO-A1-2014/207320
- FR-A1- 2 631 369
- JP-A- 2000 170 431
- US-A- 4 920 771
- US-A- 4 920 771
- US-A- 5 626 373
- US-S- D 593 970

## Description

### Background of the invention

The invention relates to an enclosure for electrical installations, the enclosure comprising a bottom part and a cover fastened to the bottom part by fastening means comprising a latch which, supported by a bearing, may be turned in relation to the bottom part to open and close the fastening means, and an arm body which is bearing-mounted to the latch, whereby the cover has a detent to receive the arm and to fasten the cover to the bottom part by means of the arm.

Enclosures of the type referred to are rather common. A fast opening and closing of the cover in relation to the bottom part may be implemented by the arm. Enclosures often stay at their application sites for years without needing to be disturbed. In this case, if the surroundings are dirty, and the enclosure needs to be opened, the fastening means may be dirty and possibly oxidized to the extent that the opening mechanism of the fastening means fails to work. If an attempt is made to open the dirty opening mechanism with too much force, it may break. Even if a cover of a dirty enclosure could be successfully opened, the enclosure may be difficult to close - and even impossible to close if the fastening mechanism has been damaged when it was opened. Due to the above, if fouling of the fastening mechanism impedes or prevents the opening of an enclosure, the fastening mechanism has to be carefully cleaned prior to opening.

An enclosure according to the preamble of claim 1 is known from document US 4920771 A.

### Brief description of the invention

It is a primary object of the invention to eliminate said problem, which is specifically related to enclosures in which the fastening mechanism of a cover comprises an arm.

The object of the invention is achieved with an enclosure according to claim 1. The enclosure comprises a cover with a detent that is located in a recess formed in an edge of the cover, whereby attached to an arm there is a cover piece adapted to attach to the detent in the recess of the cover by means of an arm whereby the cover piece additionally comprises a first outer surface and a second outer surface which at the recess of the cover make the outer surfaces of the cover uniform, when the cover is locked to a bottom part, so that the first outer surface of the cover piece is in the same plane as the top surface of the cover and the second outer surface of the cover piece is in the same plane as the side surface of the cover, and in addition so that the first outer surface and the second outer surface conceal the discontinuities formed by the recess of the cover on the top surface of the cover and correspondingly on the side surface of the cover.

Advantageously, the bottom part of the enclosure has a recess to receive the latch of the fastening means so that the latch is located in the recess of the bottom part. Such a structure reduces the outer dimensions of an enclosure and also makes the enclosure aesthetically stylish. The reduced outer dimensions naturally also allow an easier storage and packing of the enclosures, and also benefit transportation of the enclosures. Because the enclosure has not got any large, protruding fastening means, the chances of them damaging due to impacts are removed, practically speaking. When the bottom part of the enclosure has a recess to receive fastening means, the latch of the enclosure advantageously has two grooves and the cover piece has two grooves, making it possible for an arm of a straightforward shape and taking up little space to turn in relation to the latch, and correspondingly the turning of the cover piece in relation to the latch when the fastening means are opened to release the cover from the fastening means. Due to said grooves, the arm may be shaped such that it protrudes as little as possible from the outer surface of the enclosure.

The recess of the cover has advantageously a hole to fasten the cover to the bottom part with a screw. A screw makes it possible to securely fasten the cover to the bottom part without the danger of the cover detaching from the bottom part, even if the fastening means comprising the latch and arm were to open either unintentionally or due to vandalism. Due to the cover piece, the screw head is protected from dirt and the screw may be easily opened when desired. The screw may naturally be a special screw that is difficult to open because opening requires a special tool to be used.

The fastening means may comprise a body frame part in which the latch bearing is implemented, whereby the body frame part is preferably detachably fastened to a recess formed in a bottom part of the body by means of quick-release means. Such a solution allows the fastening means to be quickly replaced, if for some reason the need arises. However, such a need does not typically exist.

The preferred embodiments of the invention are disclosed in the attached claims 2 to 15.

The biggest advantage of the inventive enclosure is that the enclosure getting dirty during use does not hinder the quick opening of the enclosure because the fastening mechanism keeping the cover of the enclosure closed is protected from dirt. Furthermore, a notable advantage is also that the external appearance of the enclosure at the fastening means is smart as the outer surfaces of the cover are continuous at the fastening means without hindering protrusions or recesses.

### Brief description of the drawings

The invention will now be described in more detail by means of a preferred embodiment thereof and with reference to the accompanying drawing, in which
Figure 1 shows a general view of the enclosure according to the invention,
Figure 2 shows a blow-up of a corner of the enclosure shown in Figure 1 so that the fastening means to fasten the cover to a bottom part are visible, and
Figures 3a to 3c illustrate fastening the cover of the enclosure to the bottom part of the enclosure, and
Figure 4 is a rear view of the fastening means of the enclosure.

### Detailed description of the invention

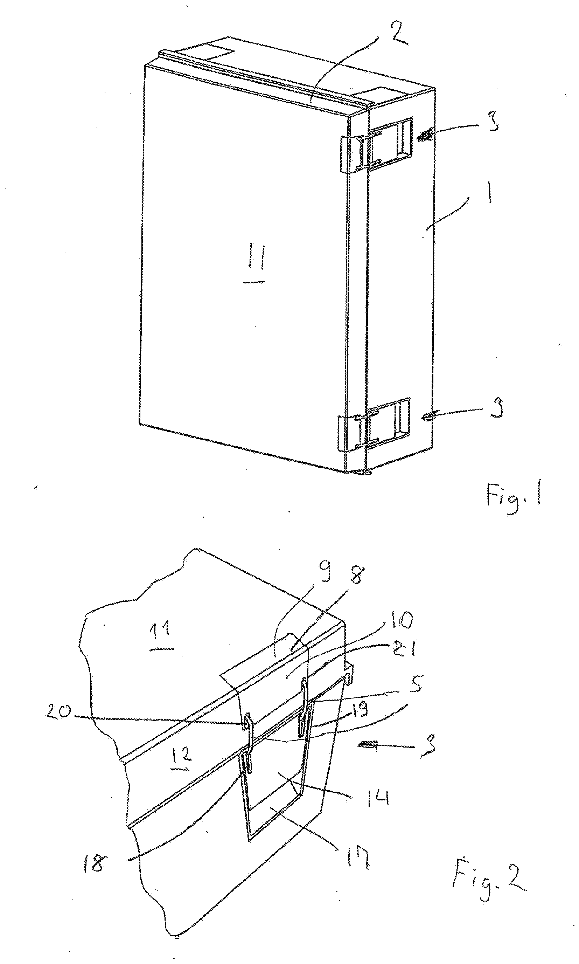

Figure 1 shows a general view of the enclosure according to the invention. The enclosure comprises a box-like bottom part 1, covered by a box-like cover 2. At one of its edges, the cover 2 is hinged to the bottom part 1 (Figure 1 does not show the hinges), but instead of the hinge there may be a screw, for example, to fasten the cover to the bottom part. In Figure 1, reference number 3 indicates easily and quickly openable fastening means to keep the cover 2 closed to the bottom part 1. In other words, the cover 2 is openably fastened to the bottom part 1 with the fastening means 3.

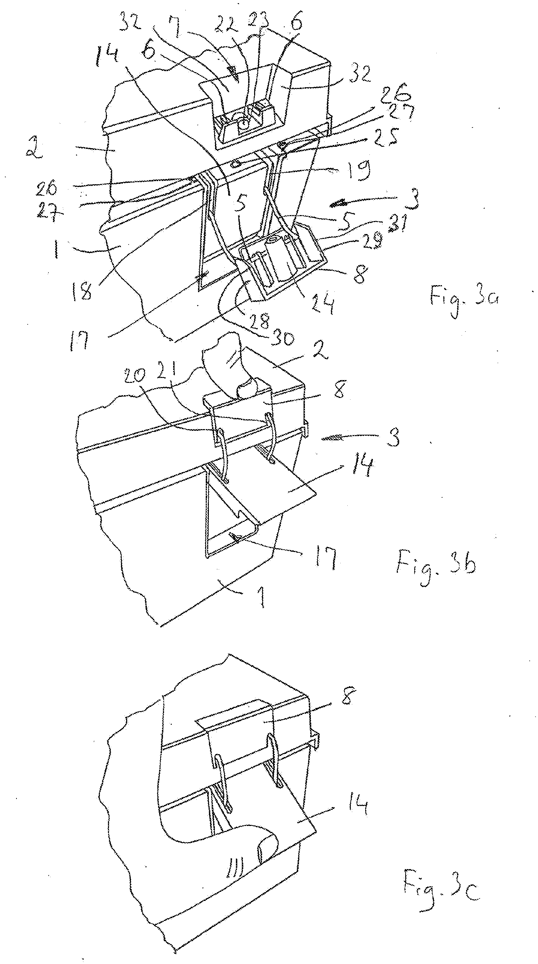

Figure 2 shows an enlarged view of the fastening means 3 of the cover 2 in the closed position, keeping the cover 2 closed. The fastening means 3 comprise a latch 14, a arm 5, and a cover piece 8. As can be seen in Figure 2, the cover piece 8 comprises a first planar outer surface 9 which is in the same plane as a top surface 11 of the cover 2, and a second planar outer surface 10 which is in the same plane as an side surface 12 of the cover. The outer surfaces 9 and 10 of the cover piece conceal the recess (recess 7 in Figure 3a) of the cover 2 so that between the outer surfaces 9 and 10 and the surrounding top surface 11 and correspondingly the side surface 12 of the cover there is no gap which in practise would allow dirt to penetrate to the recess below the cover (see recess 7 in Figure 3a).

Figures 3a to 3c illustrate closing an opened cover 2 with fastening means 3.

In Figure 3a, the cover 2 is ajar and the cover piece 8 of the fastening means is detached from the cover. In Figure 3a, reference number 6 denotes a detent in a recess 7 at an edge of the cover 2 to receive the arm 5 of the fastening means. The detent 6 is in the form of a protrusion. The arm 5 rests on the detent 6 when the fastening means 3 are in the closed position. In addition, the recess 7 has a recess 23 which is adapted to receive a protrusion part 24 that the cover piece 8 has. The edges of the recess 23 may provide guiding for the protrusion part 24 when the fastening means 3 are being closed, cf. Figures 3b and 3c. The protrusion part 24 is preferably tapered, such as conical. Similarly, the recess 23 may be widening upwards. Walls 32 of the recess 7 guide the cover piece 8 when the fastening means 3 are being closed. For this purpose, the walls 32 defining the recess 7 make the recess narrow downwards, and the cover piece 8 also comprises opposing wall parts 28, 29 which make the cover piece narrow downwards. The wall parts 28, 29 are preferably so formed that their edges 30, 31 rest on the wall 32 of the recess 7 when the cover piece 8 is being inserted downwards into place. Due to the shaping of the recess 7 and cover piece 8 (possibly also due to the recess 23 and protrusion part 24) the cover piece 8 is thus directed precisely in the correct place. When the cover 2 is the closed position, cf Figure 2, the arm 5 rests on the detent 6 and the protrusion part 24 is located in the recess 7. The detent 6 in the recess of the cover 2 and the recess 23 provide a kind of form locking for the cover piece 8. Deviating from the implementation of the Figure, the details of the form locking may be implemented in various ways, the form locking however always comprising some kind of detent in the cover (cf. detent 6 in Figure 3a). In addition to a detent, the form locking may comprise other kinds of forms in the recess of the cover (cf. recess 7 in Figure 3a) and on the inner surface of the cover piece. Therefore Figure 3a shows one way, only, to establish form locking. The recess 7 has a hole 22, too, which allows the cover 2 to be fastened to the bottom part 1 with a screw (not shown). The body frame part 24 of the fastening means 3 has a hole 25 to receive said screw, see Figure 3a.

When it is desired to close the cover 2 from the position of Figure 3a, the cover piece 8 is lifted up and the latch 14 is simultaneously lifted upwards by its lower edge. This way, the cover piece 8 can be lifted over the detent 6 and the cover piece can be adapted into the recess 7 in the cover, cf. Figure 3b. The cover piece 8 is guided with a thumb in a correct initial position, with the closing of the cover 2 in mind, cf. Figure 3b, after which the latch 14 in the open position, cf. Figure 3b, is pressed downwards, which is illustrated in Figure 3c. Then the cover piece 8 lowers controllably to a position where it conceals the recess 7 of the cover 2, cf. Figure 3c. When the latch 14 is in the closed position of Figure 2, that is, in a position where the latch is entirely located in the recess 17 of the bottom part 1, the outer surfaces 9 and 10 of the cover piece 8 are in the same plane as the top surface 11 and similarly the side surface 12 of the cover 2. In said closed position, the outer surfaces 8 and 9 of the cover piece 8 conceal the discontinuities formed by the recess of the cover on the top surface 11 and similarly on the side surface 12. In the closed position, the cover piece 8 conceals the recess 7 of the cover 2 so that there is no gap between the circumference of the cover piece 8 and the top surface and side surface 12 of the cover 2 surrounding the cover piece whereby dirt cannot, in any detrimental amount anyway, access the recess.

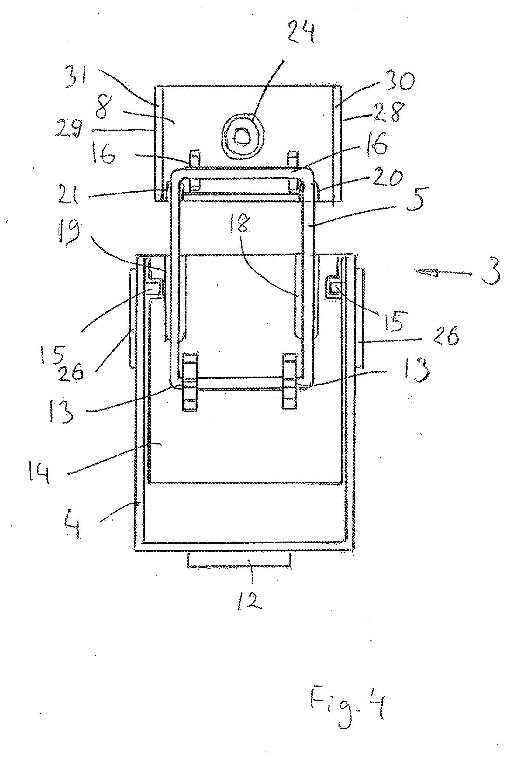

The fastening means 3 include an arm 5 which connects the latch part 14 to the cover piece 8. Figure 4, which shows the fastening means 3 as seen from the back, that is, from the inside, more closely reveals the structure of the fastening means than the other figures which show the fastening means 3 from the outside. Figure 4 shows that the arm 5 of the fastening means 3 is bearing-mounted 13 to the latch 14 and bearing-mounted 16 to the cover piece 8. The latch 14 is bearing-mounted 15 to the body frame part 4. By means of said bearing-mountings 13, 15, and 16, the fastening means 3 can be set in the positions shown in Figures 3a to 3c. Because the latch 14 of the fastening means 3 and the body frame part 4 are adapted in a recess 17 in the bottom part 1, and it is further desired that the arm 5 does not protrude obtrusively from the enclosure when the fastening means are in the closed position, the latch 3 has grooves 18, 19 and the cover piece 8 has grooves 20,21. The grooves 18, 19 allow the wide-ranging turning of the latch 14 in relation to the arm 5, cf. Figures 3a to 3c, in which the arm 5 goes in the grooves 18, 19 that the latch has. Similarly, the grooves 20, 21 in the cover piece 8 allow the wide-ranging turning of the cover piece in relation to the arm 5, cf. Figures 3a to 3c. As shown in Figure 2, the arm 5 conceals the grooves 18 to 21 rather well when the fastening means are in the closed position, as a result of which dirt cannot access through the grooves 18 to 21 in any detrimental amount to the recess (see recess 7 in Figure 3a) under the cover piece 9. As seen from Figure 2, the arm 5 of the fastening means 3 only protrudes by the material thickness of the arm from the outline of the enclosure.

The body frame part 4 of the fastening means is detachably fastened by quick-release means to the recess 17 of the bottom part 1. For this purpose, at the bottom of the body frame part 4 there is a flexible latch 12 adapted to cooperate with a collar (not shown in the figures) in the recess 17 of the bottom part. When the latch 12 is bent in the direction where it yields perpendicular to the plane formed by the body frame part of the cover part, the latch 12 will be guided behind the collar in the recess 17 and locked against the collar. The body frame part 4 can be removed from the recess 17 by bending the latch whereby the latch is released from the collar. For the body frame part 4 to provide a sturdy fastening for the fastening means 3 to the bottom part 1, the flanks of the body frame part 4 have tongues 26 that settle in matching grooves 27 in the bottom part to establish a tongue-and-groove joint. Tongues

The parts of the fastening means 3 are made of plastic, with the exception of the arm 5. The arm is made of stainless steel.

The details of the invention may be implemented in a number of ways within the scope of the attached claims. Therefore the number of the fastening means 3 in the enclosure may vary. The fastening means 3 do not necessarily have to comprise a body frame part 4, whereby the latch 14 of the fastening means is bearing-mounted 15 directly to the bottom part 1. In the latter case, if the recess 7 in the cover 2 has a hole 22 to receive a screw, the bottom part 1 similarly has a hole or recess to receive the screw. The latch 14 of the fastening means and the body frame part 4 need not necessarily be adapted in the recess 17 in the bottom part 1, although this is highly preferable with the outer dimensions of the enclosure and the risk of the fastening means 3 becoming damaged due to external impacts in mind.

## Claims

1. An enclosure for electrical installations, the enclosure comprising a bottom part (1) and a cover (2) fastened to the bottom part (1) by fastening means (3) comprising a latch (14) which, supported by a bearing (15), is turnable in relation to the bottom part (1) to open and close the fastening means (3), and an arm (5) which at its first end is bearing-mounted (13) to the latch (14), whereby the cover (2) has a detent (6) to receive the arm (5) and to fasten the cover to the bottom part (1) by means of the arm (5), wherein the detent (6) is located in a recess (7) formed in an edge of the cover (2), whereby attached to the arm (5) there is a cover piece (8) adapted to attach to the detent (6) in the recess (7) of the cover (2) by means of the arm (5) whereby the cover piece (8) additionally comprises a first outer surface (9) and a second outer surface (10) **characterized in that** the first outer surface (9) and the second outer surface (10) at the recess (7) of the cover make the outer surfaces of the cover uniform when the cover (2) is locked to the bottom part (1), so that the first outer surface (9) of the cover piece (8) is in the same plane as the top surface (11) of the cover (2) and the second outer surface (10) of the cover piece (8) is in the same plane as the side surface (12) of the cover, and in addition so that the first outer surface (9) and the second outer surface (10) conceal the discontinuities formed by the recess (7) of the cover on the top surface (11) of the cover and correspondingly on the side surface (12) of the cover, and **in that** said first outer surface (9) of the cover piece (8) is planar, and said second outer surface (10) of the cover piece (8) is planar.

2. An enclosure as claimed in claim 1, **characterized in that** the arm (5) of the fastening means (3) is bearing-mounted (16) to the cover piece (8).

3. An enclosure as claimed in claim 1 or 2, **characterized in that** the bottom part (1) features a recess (17) to receive a latch (14) of the fastening means so that the latch (14) is located in the recess (17) of the bottom part (1).

4. An enclosure as claimed in claim 3, **characterized in that** the latch (14) has two grooves (18 and 19) and the cover piece (8) has two grooves (20, 21) to make it possible for the arm (5) to turn in relation to the latch (14), and correspondingly the turning of the cover piece (8) in relation to the latch (14) to open the fastening means (3) and to release the cover (2) from the fastening means (3).

5. An enclosure as claimed in claim 4, **characterized in that** the fastening means (3) protrude from the outline defined by the bottom part (1) and cover (2) by the arm (5), at most.

6. An enclosure as claimed in claim 5, **characterized in that** the fastening means (3) protrude from the outline defined by the bottom part (1) and cover (2) by the thickness of the arm material of the arm (5), at most.

7. An enclosure as claimed in any one of the preceding claims, **characterized in that** the cover piece (8) is adapted to attach to the recess (7) in the cover (2) by form locking which comprises said detent (6).

8. An enclosure as claimed in any one of the preceding claims, **characterized in that** the fastening means (3) comprise a body frame part (4), and **in that** the bearing (15) to turn the latch (14) in relation to the bottom part (1) is formed in the body frame part (13).

9. An enclosure as claimed in claim 8, **characterized in that** the body frame part (4) of the fastening means (3) is detachably fastened to the recess (17) in the bottom part (1) of the body.

10. An enclosure as claimed in claim 9, **characterized in that** the body frame part (4) of the fastening means (3) is fastened by form locking to the recess (17) in the bottom part (1).

11. An enclosure as claimed in any one of the preceding claims, **characterized in that** the recess (7) of the cover has a hole (22) to fasten the cover (2) to the bottom part (1) by a screw.

12. An enclosure as claimed in claim 1, **characterized in that** the detent (6) of the cover (2) comprises, in the recess (7) of the cover, a protrusion part which is adapted to receive the arm (5) of the fastening means (3).

13. An enclosure as claimed in claim 1 or 12, **characterized in that** the detent (6) comprises a recess (23) adapted to receive a protrusion part (24) in the cover piece (8).

14. An enclosure as claimed in any one of the preceding claims, **characterized in that** there are walls (32) defining the recess (7) of the cover, which make the recess narrow downwards, and **in that** the cover piece (8) comprises opposing wall parts (28, 29) which make the cover piece narrow downwards.

15. An enclosure as claimed in any one of the preceding claims, **characterized in that** said top surface (11) of the cover (2) is planar, and said side surface (12) of the cover (2) is planar.

## Patentansprüche

1. Gehäuse für elektrische Installationen, wobei das Gehäuse ein Unterteil (1) und einen Deckel (2) umfasst, der an dem Unterteil (1) mit Befestigungsmitteln (3) befestigt ist, die einen Riegel (14) umfassen, der durch ein Lager (15) abgestützt in Bezug auf das Unterteil (1) drehbar ist, um die Befestigungsmittel (3) zu öffnen und zu schließen, und einen Arm (5) umfassen, der an seinem ersten Ende an dem Riegel (14) gelagert (13) ist, wodurch der Deckel (2) eine Arretierung (6) zur Aufnahme des Arms (5) und zur Befestigung des Deckels an dem Unterteil (1) mittels des Arms (5) aufweist,
wobei sich die Arretierung (6) in einer Aussparung (7) befindet, die in einem Rand des Deckels (2) ausgebildet ist, wodurch an dem Arm (5) ein Abdeckstück (8) befestigt ist, das dafür ausgelegt ist, mittels des Arms (5) an der Arretierung (6) in der Aussparung (7) des Deckels (2) befestigt zu werden, wodurch das Abdeckstück (8) zusätzlich eine erste Außenfläche (9) und eine zweite Außenfläche (10) aufweist,
**dadurch gekennzeichnet, dass** die erste Außenfläche (9) und die zweite Außenfläche (10) an der Aussparung (7) des Deckels die Außenflächen des Deckels beim Verriegeln des Deckels (2) mit dem Unterteil (1) derart gleichmäßig machen, dass die erste Außenfläche (9) des Abdeckstücks (8) in der gleichen Ebene liegt wie die obere Fläche (11) des Deckels (2) und die zweite Außenfläche (10) des Abdeckstücks (8) in der gleichen Ebene liegt wie die Seitenfläche (12) des Deckels, und zudem dass die erste Außenfläche (9) und die zweite Außenfläche (10) die durch die Aussparung (7) des Deckels gebildeten Unterbrechungen an der oberen Fläche (11) des Deckels und entsprechend an der Seitenfläche (12) des Deckels verdecken, und dadurch, dass die erste Außenfläche (9) des Abdeckstücks (8) eben ist und die zweite Außenfläche (10) des Abdeckstücks (8) eben ist.

2. Gehäuse nach Anspruch 1, **dadurch gekennzeichnet, dass** der Arm (5) der Befestigungsmittel (3) an dem Abdeckstück (8) gelagert (16) ist.

3. Gehäuse nach Anspruch 1 oder 2, **dadurch gekennzeichnet, dass** das Unterteil (1) eine Aussparung (17) zur Aufnahme eines Riegels (14) der Befestigungsmittel aufweist, so dass sich der Riegel (14) in der Aussparung (17) des Unterteils (1) befindet.

4. Gehäuse nach Anspruch 3, **dadurch gekennzeichnet, dass** der Riegel (14) zwei Nuten (18 und 19) aufweist und das Abdeckstück (8) zwei Nuten (20, 21) aufweist, um eine Drehung des Arms (5) in Bezug auf den Riegel (14) zu ermöglichen, und dementsprechend die Drehung des Abdeckstücks (8) in Bezug auf den Riegel (14) zu ermöglichen, um die Befestigungsmittel (3) zu öffnen und den Deckel (2) von den Befestigungsmitteln (3) zu lösen.

5. Gehäuse nach Anspruch 4, **dadurch gekennzeichnet, dass** die Befestigungsmittel (3) höchstens durch den Arm (5) über den durch das Unterteil (1) und den Deckel (2) definierten Umriss hinausragen.

6. Gehäuse nach Anspruch 5, **dadurch gekennzeichnet, dass** die Befestigungsmittel (3) höchstens um die Dicke des Armmaterials des Arms (5) über den durch das Unterteil (1) und den Deckel (2) definierten Umriss hinausragen.

7. Gehäuse nach einem der vorstehenden Ansprüche, **dadurch gekennzeichnet, dass** das Abdeckstück (8) dafür ausgelegt ist, an der Aussparung (7) in dem Deckel (2) durch Formschluss befestigt zu werden, der die Arretierung (6) umfasst.

8. Gehäuse nach einem der vorstehenden Ansprüche, **dadurch gekennzeichnet, dass** die Befestigungsmittel (3) ein Körperrahmenteil (4) umfassen und dadurch, dass das Lager (15) zum Drehen des Riegels (14) in Bezug auf das Unterteil (1) in dem Körperrahmenteil (13) ausgebildet ist.

9. Gehäuse nach Anspruch 8, **dadurch gekennzeichnet, dass** das Körperrahmenteil (4) der Befestigungsmittel (3) lösbar an der Aussparung (17) in dem Unterteil (1) des Körpers befestigt ist.

10. Gehäuse nach Anspruch 9, **dadurch gekennzeichnet, dass** das Körperrahmenteil (4) der Befestigungsmittel (3) durch Formschluss an der Aussparung (17) in dem Unterteil (1) befestigt ist.

11. Gehäuse nach einem der vorstehenden Ansprüche, **dadurch gekennzeichnet, dass** die Aussparung (7) des Deckels ein Loch (22) zur Befestigung des Deckels (2) durch eine Schraube an dem Unterteil (1) aufweist.

12. Gehäuse nach Anspruch 1, **dadurch gekennzeichnet, dass** die Arretierung (6) des Deckels (2) in der Aussparung (7) des Deckels ein vorstehendes Teil aufweist, das für die Aufnahme des Arms (5) der Befestigungsmittel (3) ausgelegt ist.

13. Gehäuse nach Anspruch 1 oder 12, **dadurch gekennzeichnet, dass** die Arretierung (6) eine Aussparung (23) umfasst, die dafür ausgelegt ist, ein vorstehendes Teil (24) in dem Abdeckstück (8) aufzunehmen.

14. Gehäuse nach einem der vorstehenden Ansprüche, **dadurch gekennzeichnet, dass** Wände (32) vorhanden sind, die die Aussparung (7) des Deckels begrenzen und die Aussparung nach unten verjüngen, und dadurch, dass das Abdeckstück (8) gegenüberliegende Wandteile (28, 29) aufweist, die das Abdeckstück nach unten verjüngen.

15. Gehäuse nach einem der vorstehenden Ansprüche, **dadurch gekennzeichnet, dass** die obere Fläche (11) des Deckels (2) eben ist und die Seitenfläche (12) des Deckels (2) eben ist.

## Revendications

1. Enveloppe pour installations électriques, l'enveloppe comprenant une partie de fond (1) et un couvercle (2) fixé à la partie de fond (1) par des moyens de fixation (3) comprenant un verrou (14) qui, supporté par un palier (15), peut tourner par rapport à la partie de fond (1) pour ouvrir et fermer les moyens de fixation (3), et un bras (5) qui, au niveau de sa première extrémité, est monté sur palier (13) sur le verrou (14), moyennant quoi le couvercle (2) a un encliquetage (6) pour recevoir le bras (5) et pour fixer le couvercle sur la partie de fond (1) au moyen du bras (5), dans laquelle l'encliquetage (6) est positionné dans un évidement (7) formé dans un bord du couvercle (2), moyennant quoi, fixée au bras (5), on trouve une pièce de couvercle (8) adaptée pour se fixer à la détente (6) dans l'évidement (7) du couvercle (2) au moyen du bras (5), moyennant quoi la pièce de couvercle (8) comprend, de plus, une première surface externe (9) et une seconde surface externe (10), **caractérisée en ce que** la première surface externe (9) et la seconde surface externe (10), au niveau de l'évidement (7) du couvercle, rendent les surfaces externes du couvercle uniformes lorsque le couvercle (2) est verrouillé sur la partie de fond (1), de sorte que la première surface externe (9) de la pièce de couvercle (8) est dans le même plan que la surface supérieure (11) du couvercle (2) et la seconde surface externe (10) de la pièce de couvercle (8) est dans le même plan que la surface latérale (12) du couvercle, et de plus de sorte que la première surface externe (9) et la seconde surface externe (10) dissimulent les discontinuités formées par l'évidement (7) du couvercle sur la surface supérieure (11) du couvercle et de manière correspondante sur la surface latérale (12) du couvercle, et **en ce que** ladite première surface externe (9) de la pièce de couvercle (8) est plane, et ladite seconde surface externe (10) de la pièce de couvercle (8) est plane.

2. Enveloppe selon la revendication 1, **caractérisée en ce que** le bras (5) des moyens de fixation (3) est monté sur palier (16) sur la pièce de couvercle (8).

3. Enveloppe selon la revendication 1 ou 2, **caractérisée en ce que** la partie de fond (1) propose un évidement (17) pour recevoir un verrou (14) des moyens de fixation de sorte que le verrou (14) est positionné dans l'évidement (17) de la partie de fond (1).

4. Enveloppe selon la revendication 3, **caractérisée en ce que** le verrou (14) a deux rainures (18 et 19) et la pièce de couvercle (8) a deux rainures (20, 21) pour que le bras (5) puisse tourner par rapport au verrou (14), et de manière correspondante que la rotation de la pièce de couvercle (8) par rapport au verrou (14) puisse ouvrir les moyens de fixation (3) et libérer le couvercle (2) des moyens de fixation (3).

5. Enveloppe selon la revendication 4, **caractérisée en ce que** les moyens de fixation (3) font saillie du contour défini par la partie de fond (1) et du couvercle (2) par le bras (5), au plus.

6. Enveloppe selon la revendication 5, **caractérisée en ce que** les moyens de fixation (3) font saillie du contour défini par la partie de fond (1) et du couvercle (2) par l'épaisseur du matériau de bras du bras (5), au plus.

7. Enveloppe selon l'une quelconque des revendications précédentes, **caractérisée en ce que** la pièce de couvercle (8) est adaptée pour se fixer à l'évidement (7) dans le couvercle (2) par verrouillage de forme qui comprend ledit encliquetage (6) .

8. Enveloppe selon l'une quelconque des revendications précédentes, **caractérisée en ce que** les moyens de fixation (3) comprennent une partie de bâti de corps (4), et **en ce que** le palier (15) pour faire tourner le verrou (14) par rapport à la partie de fond (1) est formé dans la partie de bâti de corps (13) .

9. Enveloppe selon la revendication 8, **caractérisée en ce que** la partie de bâti de corps (4) des moyens de fixation (3) est fixée, de manière détachable, sur l'évidement (17) dans la partie de fond (1) du corps.

10. Enveloppe selon la revendication 9, **caractérisée en ce que** la partie de bâti de corps (4) des moyens de fixation (3) est fixée, par verrouillage de forme, à l'évidement (17) dans la partie de fond (1).

11. Enveloppe selon l'une quelconque des revendications précédentes, **caractérisée en ce que** l'évidement (7) du couvercle a un trou (22) pour fixer le couvercle (2) sur la partie de fond (1) par une vis.

12. Enveloppe selon la revendication 1, **caractérisée en ce que** l'encliquetage (6) du couvercle (2) comprend, dans l'évidement (7) du couvercle, une partie de saillie qui est adaptée pour recevoir le bras (5) des moyens de fixation (3).

13. Enveloppe selon la revendication 1 ou 12, **caractérisée en ce que** l'encliquetage (6) comprend un évidement (23) adapté pour recevoir une partie de saillie (24) dans la pièce de couvercle (8).

14. Enveloppe selon l'une quelconque des revendications précédentes, **caractérisée en ce qu'**il y a des parois (32) définissant l'évidement (7) du couvercle, qui font rétrécir l'évidement vers le bas, et **en ce que** la pièce de couvercle (8) comprend des parties de paroi (28, 29) opposées, qui font rétrécir la pièce de couvercle vers le bas.

15. Enveloppe selon l'une quelconque des revendications précédentes, **caractérisée en ce que** ladite surface supérieure (11) du couvercle (2) est plane, et ladite surface latérale (12) du couvercle (2) est plane.
